Europäisches Patentamt

European Patent Office

Office européen des brevets

(11) Publication number: **0 238 643**
**B1**

# (12) EUROPEAN PATENT SPECIFICATION

(45) Date of publication of patent specification: **18.07.90**

(21) Application number: **86906177.0**

(22) Date of filing: **30.09.86**

(86) International application number:
**PCT/US86/02030**

(87) International publication number:
**WO 87/02072 09.04.87 Gazette 87/08**

(51) Int. Cl.⁵: **C 23 C 14/32, C 23 C 14/34**

(54) **APPARATUS AND PROCESS FOR ARC VAPOR DEPOSITING A COATING IN AN EVACUATED CHAMBER.**

(30) Priority: **30.09.85 US 781460**
**12.09.86 US 906514**

(43) Date of publication of application:
**30.09.87 Bulletin 87/40**

(45) Publication of the grant of the patent:
**18.07.90 Bulletin 90/29**

(84) Designated Contracting States:
**AT BE CH DE FR GB IT LI LU NL SE**

(56) References cited:
**EP-A-0 064 288**
**DE-A-3 326 043**
**JP-A-58 136 775**
**US-A-3 278 407**
**US-A-3 391 071**

(73) Proprietor: **UNION CARBIDE CORPORATION**
**39 Old Ridgebury Road**
**Danbury Connecticut 06817 (US)**

(72) Inventor: **SUE, Jiinjen Albert**
**474 Broken Bow Trail, Apt. 2007**
**Indianapolis, IN 46224 (US)**
Inventor: **TROUE, Harden, Henry**
**487 Wallstreet Pike**
**Plainfield, IN 46168 (US)**

(74) Representative: **van der Beek, George Frans, Ir.**
**et al**
**Nederlandsch Octrooibureau Scheveningseweg**
**82 P.O. Box 29720**
**NL-2502 LS 's-Gravenhage (NL)**

Courier Press, Leamington Spa, England.

**Description**

This invention relates to a physical vapor deposition arc process and apparatus for coating a substrate in an evacuated atmosphere supplied with a reactive and/or inert gas at low pressure.

Using a high current density electric arc to form a plasma for depositing a coating upon a substrate, within an evacuated chamber, through the evaporation of source material, is known in the art as the "physical vapor deposition arc process". The source material may be supplied from a solid cathode arranged in the evacuated chamber spaced apart from the substrate. The electric arc is formed between the cathode and an anode connected in circuit with a power supply located external of the chamber. The high current density arc forms a plasma in the cathode region of the arc discharge which includes atoms, molecules, ionized atoms and ionized molecules of the "cathode evaporation surface." The "cathode evaporation surface" is that surface of the cathode to which the electric arc attaches. Coating compounds may be deposited and/or formed on the substrate by introducing reactive gases into the chamber adapted to react with the metal vapor in the plasma.

The physical vapor deposition arc process as it is conventionally known and practiced is shown and described in U.S. Patent Nos. 3,625,848; 3,783,231; 3,836,451; and 3,793,179, respectively. In accordance with conventional practice and as taught in the above-mentioned patents, a reactive gas can be introduced into the evacuated chamber to react with the source material for forming a coating compound but is otherwise considered irrelevant to the process. Moreover, the method of gas introduction and location in the arc chamber is not considered by those skilled in the art to have significance.

It has been found in accordance with the present invention that the deposition of source material in the physical vapor deposition arc process may be controlled by introducing a reactive or inert gas into the evacuated chamber in a predetermined manner as will be elaborated upon hereafter. It has been further discovered that the reactive or inert gas may be introduced into the evacuated chamber in a manner which provides adjustable control over the properties and characteristics of the coating. In fact, the method of the present invention can be used to control the crystal orientation of the deposited polycrystalline coating compound. Control over the crystal orientation and residual stress of titanium nitride (TiN) coating using a solid titanium cathode, or zirconium nitride (ZrN) coating using a solid zirconium cathode, and nitrogen-reactive gas as the source materials forms the basis of corresponding patent application WO87/0207 entitled "Titanium Nitride and Zirconium Nitride Coating Compositions, Coated Articles and Method of Manufacture" herein incorporated by reference. In addition to the control provided over the characteristics of the coating, the process and apparatus of the present invention improve the operation of the physical vapor deposition arc process by maximizing confinement of the arc to the "cathode evaporation surface" and minimizing the potential of the arc to extinguish during operation. Furthermore, the process and apparatus of the present invention permits continuous, stable operation of the apparatus for depositing a coating from the cathode over an extended time period of up to three or four times greater than that operated with the prior art.

The present invention provides a process and apparatus for vapor depositing a coating comprising source material derived from the cathode onto an object in an evacuated chamber using a high current density arc and provides an improved process and apparatus for vapor depositing a coating comprising source material from a solid cathode upon an object in an evacuated chamber under conditions which permit the cathode to be evaporated continuously and stably for an extended time period.

In the improved physical vapor disposition arc process of the present invention an object is coated with source material in a vacuum chamber from a solid cathode having an evaporable end surface spaced apart from an anode and facing said object, comprising the steps of:

generating an electric arc between the evaporable end surface of said cathode and said anode to form a plasma containing any one or more of atoms, ionized atoms, molecules and ionized molecules of said evaporable end surface;

surrounding the cathode with an elongated member having an open end extending a distance of x/d of from 0.07 to 2 for forming a cathode chamber containing said plasma between said evaporable end surface and said open end where "x" represents the axial dimension between said evaporable end surface and the open end and "d" represents the major dimension of the cross section of said evaporable end surface, said elongated member being substantially uniform in cross-sectional dimension over its length and being positioned between and spaced from said cathode and said anode;

directing a flow of gas in the narrow space between the cathode and the surrounding elongated member through the plasma in said cathode chamber and into the vacuum chamber such that the gas envelopes the electric arc over at least the distance "x" before entering the vacuum chamber, the gas pressure in the plasma cathode chamber communicating with the evacuated main chamber being relatively higher than the predetermined operating pressure established within the vacuum chamber, and that gas is fed at a rate such that said operating pressure is maintained within a desired range; and

withdrawing gas from the vacuum chamber to maintain a predetermined pressure within the vacuum chamber.

The apparatus for depositing source material upon an object in a vacuum chamber from a cathode having an evaporable end surface spaced apart from an anode and facing said object, comprising:

power supply means for generating an electric arc between the evaporable end surface of said cathode and said anode;

a sleeve surrounding the cathode having an open end projecting a distance of x/d of from 0.07 to 2 for forming a cathode chamber containing said plasma between said evaporable end surface and said open end where "x" represents the axial dimension between said evaporable end surface and the open end and "d" represents the major dimension of the cross section of said evaporable end surface, said sleeve being substantially uniform in cross-sectioned dimension over its length and being positioned between and spaced from said cathode and said anode;

gas supply means for directing a flow of gas in the narrow space between the cathode and the surrounding elongated member through the cathode chamber and into the vacuum chamber such; and

evacuating means for withdrawing the gas injected into the vacuum chamber to maintain a predetermined pressure in the vacuum chamber.

The present invention will be best understood from the following detailed description when read in conjunction with the accompanying drawings of which:

Figure 1 is a side view elevation partly in cross-section and partly schematic of the apparatus of the present invention;

Figure 2 is an enlargement of the cathode assembly of Figure 1 after operating for an extended period of time with the cathode shown partially evaporated and with a buildup of evaporated material shown on the inside wall surface of the elongated member;

Figures 2A, 2B, and 2C are respective end views of alternate geometries for the cathode and the elongated member;

Figure 3A is a micrograph showing a cross-sectional view of the microstructure of a TiN coating formed by using prior art physical vapor deposition arc process and apparatus;

Figure 3B is a micrograph showing a cross-sectional view of the microstructure of an improved TiN coating formed by arc evaporation in accordance with the physical vapor deposition arc process of the present invention; and

Figure 4 is a graph comparing the erosion characteristics of a prior art physical vapor deposition arc evaporated TiN coating versus impact angle against an improved TiN coating formed by the apparatus and method of the present invention.

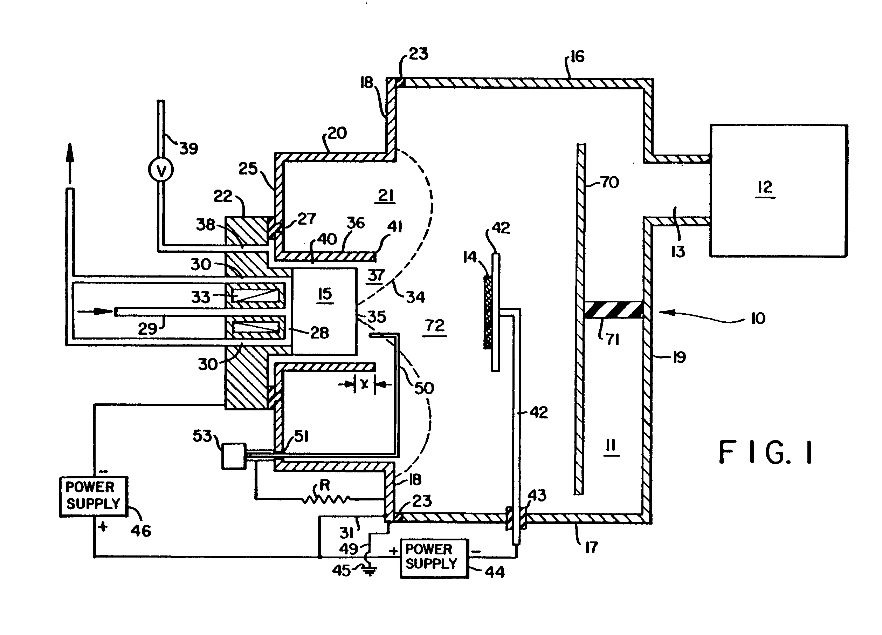

Referring now to Figure 1, in which the electric arc physical vapor deposition apparatus of the present invention is shown comprising a shell 10 having a vacuum chamber 11 which is evacuated to a desired operating pressure of between 13,3 and $6,675 \cdot 10^{-2}$ Pa ($10^{-1}$ to $5 \times 10^{-4}$ torr) and preferably between 6,675 and 0,6675 Pa ($5 \times 10^{-2}$ and $5 \times 10^{-3}$ torr) by a conventional vacuum pumping system 12 communicating with the vacuum chamber 11 through an open port 13.

The vacuum chamber 11 may have any desired geometry and be of any desired size to accommodate one or more objects 14 (substrates) to be coated with source material provided by evaporating one or more solid cathodes 15 in accordance with the practice of the present invention. For illustrative purposes, the shell 10 is shown having a generally rectangular body which, in cross-section, has an upper wall 16, a lower wall 17, and side walls 18 and 19, respectively. The shell 10 further can include an additional section 20 which projects an arbitrary distance from the side wall 18. The side wall 18 has an opening 21 through which the cathode 15 communicates with the vacuum chamber 11.

The cathode 15 is attached to a cathode support assembly 22. The cathode support assembly 22 is mounted on a flange 25 through an insulator 27. The mounting flange 25 is connected to section 20 of the shell 10. The support block 22 has a relatively small cavity 28 which connects with an inlet passage 29 and exit passages 30. A coolant such as water is circulated through the cavity 28 from a source (not shown). The coolant flows from the source through inlet conduit 29 into the cavity 28 and returns to the source through the exit passages 30. A DC magnet 33 is disposed within the support block 22 and serves to diffuse the point of attachment of an electric arc 34 over the arc evaporation surface 35 of the cathode 15.

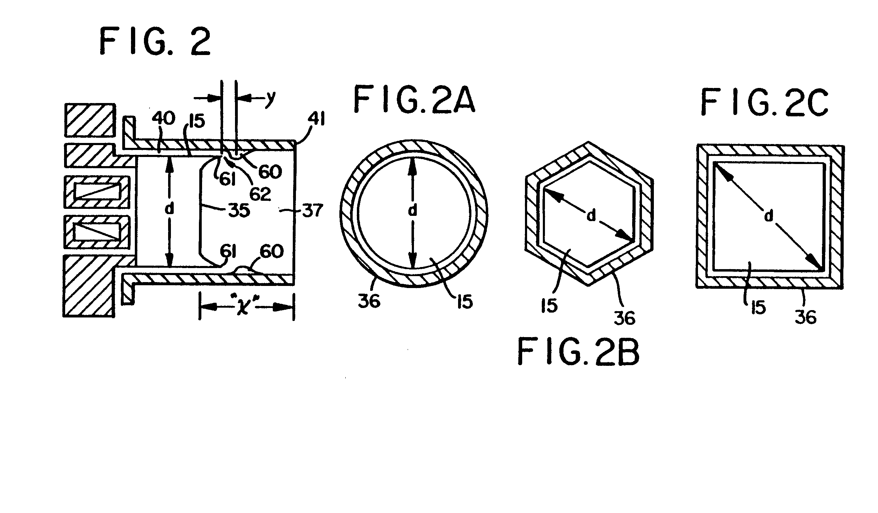

A hollow elongated member 36 surrounds the cathode 15 to form a relatively narrow space 40. The elongated member 36 is attached to the mounting flange 25 through the insulator 27. The geometry of the member 36 and open end 41 should substantially conform to the geometry and dimension of the cathode 15 as shown in Figures 2A, 2B and 2C, respectively. The elongated member 36 should be substantially uniform in cross-sectional dimension over its length. This assures that the open end 41 does not restrict the plasma flow as it exits member 36. Accordingly, if a cylindrical or disk shaped cathode is used, the member 36 should preferably be tubular in shape with the narrow space 40 being annular in cross-section. For a 6.35 cm diameter cathode the thickness of the annular space 40 can range from about 0.08 cm to about 0.24 cm. An inlet opening 38 in the support block 22 directly communicates with the narrow space 40 and with an input gas supply line 39. Gas is fed through the gas supply line 39 from a source of gas (not shown) into the narrow space 40 from whence the gas is directed through the cathode chamber 37 into the vacuum chamber 11. A valve V is used to control the flow of gas through the supply line 39.

The elongated member 36 projects a predetermined distance "x" beyond the cathode evaporable end surface 35 to form a cathode chamber 37. The extension "x" between the open end 41 of the member 36 and the evaporable end surface 35 must be above zero and up to a maximum of, for example, about 13 cm in length for a 6.35 cm diameter cathode. The distance "x" is measured from the cathode evaporable end surface 35 as shown in Figure 2 to the open end 41 of the elongated member 36. The preferred minimum

3

distance "x" is at least about one centimeter and the preferred range for "x" is between 2 to 6 cm for a 6.35 cm diameter cathode. Similar aspect ratios of "x", herein defined as x/d where "d" is the major dimension of the cathode evaporable end surface 35, must be maintained for all cathode geometries such as those shown in Figures 2A, 2B and 2C, respectively. The aspect ratio must be above zero and up to a maximum of about 2.0. The preferred minimum aspect ratio is at least about 0.07 and the preferred range of the aspect ratio is between 0.3 and 1.0. The critical requirement and importance of recessing the cathode within the member 36 to form a cathode chamber 37 will be discussed at greater length later in the specification. The elongated member 36 may preferably be composed of any material that does not interfere with the function of magnet 33 in diffusing the attachment of electric arc 34 over the arc evaporation surface 35 and can comprise any non-magnetic material suitable for high temperature vacuum service, e.g., non-magnetic stainless steel.

The object 14 is mounted upon a support plate 42 located within the vacuum chamber 11 and spaced apart from the evaporable end surface 35 of the cathode 15. The type of structure used to support or suspend the object 14 within the vacuum chamber 11 depends upon the size, configuration and weight of the object. For simplicity, the object 14 is shown having a rectangular geometry with a flat surface facing the cathode evaporation end surface 35. It should be understood that the object 14 may have any configuration and may be supported in any fashion. The object 14 may also be of any suitable composition capable of withstanding the high temperature, vacuum conditions existing in the chamber 11 and can be made of such materials as refractory metal, refractory alloy, superalloy, stainless steel, and ceramic composites. The support plate 42 should, however, be composed of a conductive material and is connected to a metal rod 42 which extends through an insulated high voltage feed-through port 43 in the lower wall 17 of the shell 10. The metal rod 42 is connected to the negative terminal of a bias power supply 44 located external of the shell 10 with the positive terminal of the bias power supply 44 connected to side wall 18 through electrical lead 31.

The vacuum chamber 11 further can include an electrically insulated surface 70 located opposite the cathode evaporable end surface 35 with the object 14 and support plate 42 positioned therebetween. The electrically insulated surface 70 can be itself comprised of an insulator material or can be comprised of a conductive material which is insulated from the chamber 10 by insulator 71 shown. This electrically insulated surface 70 serves to substantially confine the plasma to the chamber volume 72 between surface 70 and cathode evaporable end surface 35 wherein the object 14 is located without surface 70 attracting ions or electrons from the plasma and further serves to prevent interaction between plasmas when multiple evaporators are accommodated in chamber 11.

Arc current is supplied from a main power supply 46 located external of the shell 10. The main power supply 46 has its negative terminal connected to the cathode support block 22 and its positive terminal connected to the side wall 18. The electric arc 34 is formed between the cathode 15 and the side wall 18 of the shell 10. The side wall 18 represents the anode and can be connected to ground potential 45 through an electrical lead 49. Alternatively, the anode may be formed from another conductive member (not shown) mounted adjacent to but electrically separated from the side wall. The geometry of such anode would not be critical. In the latter case, the arc conduit can be electrically isolated from the shell 10. It is also obvious that the side wall 18 can be electrically insulated from the other walls of the shell 10 by using insulating separators such as those shown at 23. It is also obvious that the anode side wall 18 can be free-floating with the ground at 45 removed and the shell wall 16, 17 and 19 grounded.

Any conventional arc starting procedure may be used including physically contacting the cathode end surface 35 with a wire electrode 50. The wire electrode 50 is electrically connected to anode side wall 18 or a separate anode (not shown) through a high resistance R. In addition the wire electrode 50 is connected to a plunger assembly 53 through an insulated sleeve 51 in the mounting flange 25. The plunger assembly 53 moves the wire electrode into physical contact with the cathode end surface 35 and then retracts it. A conventional plunger assembly for performing this operation is taught and described in U.S. Patent No. 4,448,799. However, any mechanism capable of moving the starting wire electrode 50 into contact with the cathode 15 and withdrawing it may be used to practice the present invention. Alternatively, an arc may be started by other conventional methods including transferred arc starting and spark starting using a spark plug.

In touch starting, once contact is made between the starting wire electrode 50 and the cathode 15, current flows from the main power supply 46 through the cathode 15 and wire electrode 50 to anode side wall 18. Retraction of the wire electrode 50 breaks contact with the cathode 15 to form an electric arc. The high resistance R causes the arc to transfer to the anode side wall 18 which is a less resistive path than the path to the wire electrode 50.

Any gas may be supplied to the cathode chamber 37 and then to vacuum chamber 11 through the narrow space 40 of elongated member 36 depending upon the coating to be formed on the object 14. The use of an inert gas such as argon is preferred for depositing a coating of elemental or alloy source material corresponding to the cathode material, e.g., Si, Cu, Al, W, Mo, Cr, Ta, Nb, V, Hf, Zr, Ti, Ni, Co, Fe and their alloys including alloying elements Mn, Si, P, Zn, B and C. The inert gas in this instance is not intended to react with the metal vapor in the plasma. Other inert gases that may be used include neon, krypton, xenon and helium. Reactive gases include nitrogen, oxygen, hydrocarbons such as $CH_4$ and $C_2H_2$, carbon dioxide, carbon monoxide, diborene ($B_2H_6$), air, silane ($SiH_4$) and combinations. Nitrogen is used as the preferred reactive gas with metal vapor from metal cathodes including Ti, Zr, Hf, V, Nb, Ta, Cr, Mo, W, Si and Al to form refractory nitride coatings TiN, $Ti_2N$, ZrN, HfN, VN, $V_3N$, $Nb_2N$, NbN, TaN, $Ta_2N$, CrN, $Cr_2N$, MoN, $Mo_2N$, $Mo_3N$, WN, $W_2N$, $Si_3N_4$, AlN and their compounds. Nitride-metal composites such as TiN-Ni and ZrN-Ni and complex nitrides such as (Ti, Zr)N, (Ti, Al, V)N and (Ti, V)N can be produced by employing multiple or composite cathodes. Accordingly, carbide, oxide and boride compound coatings can be produced when a reactive gas comprised of carbon, oxygen and boron is used, for example TiC, TiO, $TiO_2$ and $TiB_2$. In addition, interstitial nitride-, carbide-, boride- and oxide-compound coatings can also be made by employing more than one reactive gas species, for example, TiCN, TiON and TiOCN. In all cases, the gas should be fed into the cathode chamber 37 and then into the vacuum chamber 11 at rate compatible with the withdrawal rate of the vacuum pumping system to maintain the desired operating pressure of between 13,3 and $6,675 \cdot 10^{-2}$ Pa ($10^{-1}$ to $5 \times 10^{-4}$ torr).

The plasma produced by the high current density arc includes atoms, molecules, ionized atoms and ionized molecules of the cathode evaporation surface 35 and ionized species of gases. Biasing the object 14 negatively with respect to the anode or to both the anode and cathode influences the smoothness, uniformity and surface morphology of the coating. The bias power supply should be adjusted to a bias potential to optimize the coating operation. For a TiN, or ZrN, coating a bias potential for power supply 44 of between 50 and 400 volts is acceptable with a bias potential between 100 and 200 volts preferred for TiN and a bias potential between 50 and 250 volts preferred for ZrN.

Gas is fed through the space 40 into the cathode chamber 37 representing the volume of space between the cathode evaporation surface 35 and the open end 41 of the elongated member 36. The gas envelops the high current density arc in the cathode chamber 37 over the distance "x" resulting in an increase of plasma pressure and temperature. The plasma extends from the cathode evaporation surface 35 through the relatively high pressure region in the cathode chamber 37 and exits through the open end 41 of the elongated member 36 towards the relatively lower pressure region in the vacuum chamber 11, or chamber volume 72, where the negatively biased substrate 14 is located. An additional benefit of feeding gas through the narrow space 40 into cathode chamber 37 is that the gas in space 40 serves as an insulator to prevent arcing from the cathode 15 to the member 36.

During operation, some of the evaporated cathode material will deposit on the inside surface of the member 36 to form a deposit 60. This is diagrammatically illustrated in Figure 2. The gas injected from narrow space 40 prevents the deposit 60 from accumulating and bridging over to the cathode 15. Instead, as the operation proceeds, a convergent nozzle 62 is formed between the deposit 60 and the outer edge 61 of the cathode 15. The outer edge 61 becomes more pronounced as the evaporable end surface 35 is consumed. The gas flows through this convergent nozzle 62 across the face 35 of cathode 15 and into the plasma contained in cathode chamber 37. After prolonged operation, both the evaporable end surface 35 and the outer edge 61 recede enlarging the distance "x". The enlargement in the distance "x" is less than about 0.35 cm during normal operation and is therefore insignificant to the method of the invention. The deposit 60 apparently continues to accumulate as the edge 61 recedes so as to maintain the dimension "y" of the convergent nozzle 62 substantially constant by shifting its position in conjunction with the eroded outer edge 61. The dimension "y" is maintained substantially constant at a value greater than zero and less than about 0.4 cm over the range of operating parameters. Control over the dimension "y" results from the method of introducing gas into the cathode chamber 37. Accordingly, the operation of the convergent nozzle 62 is a self-correcting phenomenon which assures that the gas continues to be directed across the face 35 of the cathode 15 as it flows into the cathode chamber 37 from narrow space 40. In accordance with the present invention, the gas must always first enter the cathode chamber 37 before the gas enters the vacuum chamber 11, or chamber volume 72.

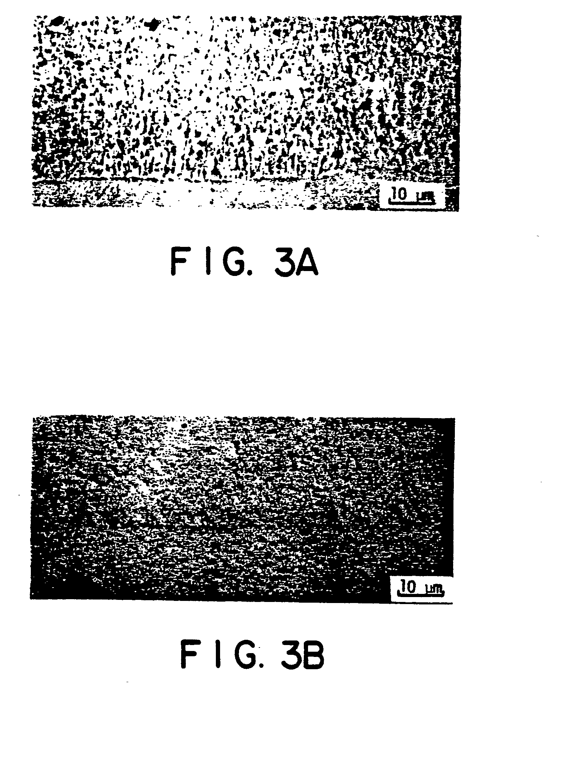

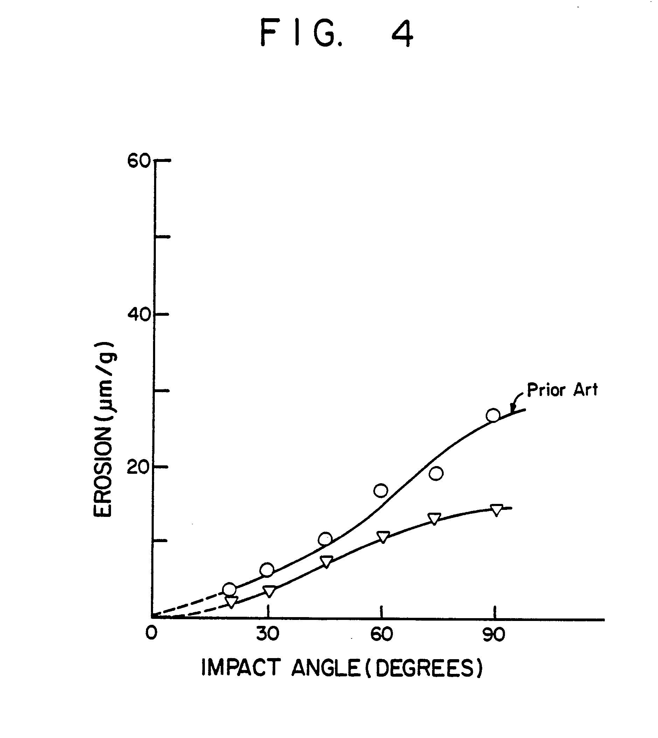

The microstructure of the coating is altered by the process of the present invention and more particularly by adjustment of the distance "x" with all other process variables held constant. Figures 3A and 3B show a comparison between the microstructure of a TiN coating formed in accordance with prior art practice and in accordance with the process of the present invention. As is apparent from Figure 3B relative to Figure 3A, the coating produced by the apparatus and method of the present invention is a sound, dense structure with a smooth surface. It was further observed that adjustment of the distance "x" will vary the physical properties of the coating such as its erosion characteristics. The graph of Figure 4 compares the erosion characteristics of a prior art physical vapor deposition arc evaporated TiN coating with a TiN coating formed in accordance with the present invention. The degree of erosion is measured against the impact angle at which the eroding alumina material is directed. The TiN coating formed in accordance with the present invention using a recess distance of 5.7 cm for "x" and a 6.35 cm diameter cathode results in a relatively flat low erosion characteristic even at impact angles between sixty to ninety degrees compared to the prior art TiN coating which has a comparatively poor erosion characteristic particularly at high impact angles.

Examples 1 and 2

Examples 1 and 2 further illustrate the invention and are carried out in the apparatus shown in Figure 1 using the materials and process parameters given in Table I below to produce TiN and ZrN coated substrates, respectively, having the I(111)/I(200) intensity ratios, the interplanar spacing values, $d_{111}$, and 90° volume (50 μm alumina) erosion rate given below for each of Examples 1 and 2. The 90° volume erosion rate test is carried out by impacting angular 50 µm alumina particles using test apparatus based upon ASTM G 76—83 guidelines. The test uses compressed air at 248 KPa to deliver at least a 200 g charge of angular 50 µm alumina particles through a 5 mm diameter nozzle at a nominal rate of 450 g/min. with a nominal velocity of 60 m/s and a nozzle-to-specimen standoff of 10 cm at an impact angle of 90° to the specimen surface.

TABLE I

| | Example 1 | Example 2 |
|---|---|---|
| Coating Composition | TiN | ZrN |
| I(111)/I(200) | 175 | 55 |
| $d_{(111)}$ | 2.455 Å | 2.656 Å |
| 90° Volume Erosion Rate | $8.5 \times 10^{-3}$ mm³/g | $5.7 \times 10^{-3}$ mm³/g |
| Substrate | 410SS | IN718 |
| Cathode Composition | Ti | Zr |
| Cathode (cylindrical) Diameter | 6.35 cm | 6.35 cm |
| Dimension "x" | 3.8 cm | 2.6 cm |
| Spatial Standoff Chamber Pressure | 39 cm 2,3994 Pa (0.018 torr) | 30 cm 5,5986 Pa (0.042 torr) |
| $N_2$ Gas Flow | 340 sccm | 215 sccm |
| Arc Current | 125 Adc | 139 Adc |
| Substrate Bias | 150 Vdc | 250 Vdc |
| Deposition Rate | 0.065 µm/min. | 0.092 µm/min. |
| Substrate Temp. | 480°C | 670°C |

TiN and ZrN coatings have been successfully applied on a number of substrate materials such as refractory metals including Ti, Zr, V, Ta, Mo and W, superalloys including Inconel 718, Inconel 738, Waspaloy and A-286, stainless steels including 17-4PH, AISI 304, AISI 316, AISI 403, AISI 422, AISI 410, and AM355, Ti alloys including Ti-6Al-4V and Ti-6Al-2Sn-4Zr-2Mo and Ti-8Al-1Mo-1V, aluminum alloys including 6061 and 7075, WC-CO Cermet, and $Al_2O_3$ ceramics. The above-identified substrates are described in detail in Materials Engineering/Materials Selector '82, published by Penton/IPC, subsidiary of Pittway Corporation, 1111 Chester Ave., Cleveland, Ohio 44114, in 1981, and Alloy Digest, published by Alloy Digest, Inc., Post Office Box 823, Upper Montclair, New Jersey, in 1980.

**Claims**

1. A process for coating an object with source material in a vacuum chamber from a solid cathode having an evaporable end surface spaced apart from an anode and facing said object, comprising the steps of:

generating an electric arc between the evaporable end surface of said cathode and said anode to form a plasma containing any one or more of atoms, ionized atoms, molecules and ionized molecules of said evaporable end surface;

surrounding the cathode with an elongated member having an open end extending a distance of x/d of from 0.07 to 2 for forming a cathode chamber containing said plasma between said evaporable end surface (35) and said open end where "x" represents the axial dimension between sid evaporable end surface (35) and the open end and "d" represents the major dimension of the cross section of said evaporable end surface, said elongated member being substantially uniform in cross-sectional dimension over its length and being positioned between and spaced from said cathode and said anode;

directing a flow of gas in the narrow space between the cathode and the surrounding elongated member through the plasma in said cathode chamber and into the vacuum chamber such that the gas

**EP 0 238 643 B1**

envelopes the electric arc over at least the distance "x" before entering the vacuum chamber, the gas pressure in the plasma cathode chamber communicating with the evacuated main chamber being relatively higher than the predetermined operating pressure established within the vacuum chamber, and that gas is fed at a rate such that said operating pressure is maintained within a desired range; and

withdrawing gas from the vacuum chamber to maintain a predetermined pressure within the vacuum chamber.

2. A process as defined in claim 1 wherein said gas is inert and is selected from the class consisting of argon, neon, krypton, xenon, helium and combinations thereof.

3. A process as defined in claim 1 wherein said gas is reactive and is selected from the class consisting of nitrogen, oxygen, hydrocarbons, carbon dioxide, carbon monoxide, diborane, air, silane and combinations.

4. A process is defined in one of the claims 1—3 wherein said gas serves as an insulator between said cathode and said elongated member.

5. A process as defined in one of the preceding claims wherein said object is biased negatively relative to said anode.

6. A process as defined in one of the preceding claims wherein said object is biased negatively relative to both said anode and the cathode.

7. A process according to claim 6 wherein said negative bias potential is between 50 and 400 volts.

8. A process according to one of the preceding claims wherein said vacuum chamber is evacuated to an operating pressure of between 13,3 and 6,675 · 10$^{-2}$ Pa (10$^{-1}$ and 5×10$^{-4}$ torr).

9. A process according to one of the preceding claims wherein said object is deposited on said elongated member within said cathode chamber to form a converging nozzle having a nozzle aperture "y" of greater than zero and less than .4 cm.

10. A process according to one of the preceding claims, wherein said object is composed of a material selected from the class consisting of a refractory metal, superalloy, stainless steel, ceramic composites and titanium alloy.

11. A process according to one of the preceding claims wherein said object is positioned between said solid cathode evaporable end surface and an electrically insulated surface.

12. Apparatus for depositing source material upon an object (14) in a vacuum chamber (11) from a cathode (15) having an evaporable end surface (35) spaced apart from an anode (18) and facing said object (14), comprising:

power supply means (46) for generating an electric arc between the evaporable end surface (35) of said cathode (15) and said anode (18);

a sleeve (36) surrounding the cathode (15) having an open end projecting a distance of x/d of from 0.07 to 2 for forming a cathode chamber (37) containing said plasma between said evaporable end surface (35) and said open end where "x" represents the axial dimension between said evaporable end surface (35) and the open end and "d" represents the major dimension of the cross section of said evaporable end surface (35), said sleeve (36) being substantially uniform in cross-sectioned dimension over its length and being positioned between and spaced from said cathode (15) and said anode (18);

gas supply means (39) for directing a flow of gas in the narrow space (40) between the cathode and the surrounding elongated member through the cathode chamber (37) and into the vacuum chamber (11); and

evacuating means for withdrawing the gas injected into the vacuum chamber (11) to maintain a predetermined pressure in the vacuum chamber (11).

13. Apparatus as defined in claim 12 wherein said power supply means for generating said electric arc includes power supply means (46) located external of said vacuum chamber (11).

14. Apparatus according to one of the claims 12 or 13 wherein said sleeve (36) surrounding the cathode (15) is composed of non-magnetic material.

15. Apparatus according to one of the claims 12—14 wherein said sleeve (36) has a geometrical shape substantially corresponding to the geometrical shape of said cathode (15).

16. Apparatus according to one of the claims 12—15 wherein said sleeve (36) and cathode (15) are cylindrical in shape with said narrow space (40) being annular in cross section.

17. Apparatus according to one of the claims 12—16 wherein said anode is an integral part of said vacuum chamber (11).

18. Apparatus according to one of the claims 12—17 wherein said anode is connected to ground potential.

19. Apparatus according to one of the claims 12—16 wherein said anode is isolated electrically from said vacuum chamber.

20. Apparatus according to one of the claims 12—19 wherein the surface of an electrically insulated member (70) is positioned opposite said cathode evaporable end surface (35).

21. Apparatus as defined in claim 20, wherein said object (14) is placed between said surface of electrically insulated member (70) and said cathode evaporable end surface (35).

22. Apparatus according to one of the claims 12—21 wherein said vacuum chamber is at an operating pressure of between 13,3 and 6,675 · 10$^{-2}$ Pa (10$^{-1}$ and 5×10$^{-4}$ torr).

7

# EP 0 238 643 B1

## Patentansprüche

1. Verfahren zum Beschichten eines Objekts mit Quellenwerkstoff in einer Vakuumkammer von einer festen Kathode, die eine verdampfbare Stirnfläche aufweist, welche in Abstand von einer Anode angeordnet und dem Objekt zugewendet ist, bei dem:

ein elektrischer Lichtbogen zwischen der verdampfbaren Stirnfläche der Kathode und der Anode erzeugt wird, um ein Plasma zu bilden, das Atome und/oder ionisierte Atome und/oder Moleküle und/oder ionisierte Moleküle der verdampfbaren Stirnfläche enthält;

die Kathode mit einem ein offenes Ende aufweisenden, langgestreckten Bauteil umgeben wird, das sich über eine Strecke von x/d von 0,07 bis 2 erstreckt, um eine das Plasma enthaltende Kathodenkammer zwischen der verdampfbaren Stirnfläche (35) und dem offenen Ende zu bilden, wobei "x" die axiale Abmessung zwischen der verdampfbaren Stirnfläche (35) und dem offenen Ende darstellt und "d" die Hauptabmessung des Querschnittes der verdampfbaren Stirnfläche darstellt und wobei das langgestreckte Bauteil über seine Länge hinweg eine im wesentlichen gleichförmige Querschnittsabmessung hat und zwischen der Kathode und der Anode in Abstand von diesen angeordnet ist;

ein Gasstrom derart in den engen Raum zwischen der Kathode und dem umgebenden langgestreckten Bauteil durch das Plasma in der Kathodenkammer hindurch und in die Vakuumkammer hinein geleitet wird, daß das Gas den elektrischen Lichtbogen über mindestens die Strecke "x" vor dem Eintritt in die Vakuumkammer umhüllt, wobei der Gasdruck in der mit der evakuierten Hauptkammer in Verbindung stehenden Plasmakathodenkammer relativ höher als der in der Vakuumkammer ausgebildete vorbestimmte Arbeitsdruck ist und wobei Gas in solcher Menge zugeführt wird, daß der Arbeitsdruck innerhalb eines gewünschten Bereiches gehalten wird; und

Gas aus der Vakuumkammer abgezogen wird, um einen vorbestimmten Druck innerhalb der Vakuumkammer aufrechtzuerhalten.

2. Verfahren nach Anspruch 1, wobei das Gas inert ist und aus der aus Argon, Neon, Krypton, Xenon, Helium und Kombinationen dieser Gase bestehenden Gruppe ausgewählt wird.

3. Verfahren nach Anspruch 1, wobei das Gas reaktionsfähig ist und aus der aus Stickstoff, Sauerstoff, Kohlenwasserstoffen, Kohlendioxid, Kohlenmonoxid, Diboran, Luft, Silan und Kombinationen dieser Gase bestehenden Gruppe ausgewählt wird.

4. Verfahren nach einem der Ansprüche 1 bis 3, wobei das Gas als Isolator zwischen der Kathode und dem langgestreckten Bauteil dient.

5. Verfahren nach einem der vorhergehenden Ansprüche, wobei das Objekt gegenüber der Anode negativ vorgespannt wird.

6. Verfahren nach einem der vorhergehenden Ansprüche, wobei das Objekt gegenüber sowohl der Anode als auch der Kathode negativ vorgespannt wird.

7. Verfahren nach Anspruch 6, wobei das negative Vorspannungspotential zwischen 50 und 400 Volt liegt.

8. Verfahren nach einem der vorhergehenden Ansprüche, wobei die Vakuumkammer auf einen Arbeitsdruck zwischen 13,3 und $6,675 \times 10^{-2}$ Pa ($10^{-1}$ und $5 \times 10^{-4}$ torr) evakuiert wird.

9. Verfahren nach einem der vorhergehenden Ansprüche, wobei eine Abscheidung auf dem langgestreckten Bauteil innerhalb der Kathodenkammer erfolgt, um eine konvergierende Düse mit einer Düsenöffnung "y" zu bilden, die größer als Null und kleiner als 0,4 cm ist.

10. Verfahren nach einem der vorhergehenden Ansprüche, wobei das Objekt aus einem Werkstoff besteht, der aus der aus feuerfestem Metall, Superlegierung, rostfreiem Stahl, Keramik-Verbundstoffen und Titanlegierung bestehenden Gruppe ausgewählt wird.

11. Verfahren nach einem der vorhergehenden Ansprüche, wobei das Objekt zwischen der verdampfbaren Stirnfläche der festen Kathode und einer elektrisch isolierten Oberfläche angeordnet wird.

12. Vorrichtung zum Abscheiden von Quellenwerkstoff auf einem Objekt (14) in einer Vakuumkammer (11) von einer Kathode (15), die eine verdampfbare Stirnfläche (35) aufweist, welche in Abstand von einer Anode (18) angeordnet und dem Objekt (14) zugewendet ist, mit:

einer Energieversorgungsanordnung (46) zum Erzeugen eines elektrischen Lichtbogens zwischen der verdampfbaren Stirnfläche (35) der Kathode (15) und der Anode (18);

einer die Kathode (15) umgebenden und ein offenes Ende aufweisenden Hülse (36), die um eine Strecke von x/d von 0,07 bis 2 vorragt, um eine das Plasma enthaltende Kathodenkammer (37) zwischen der verdampfbaren Stirnfläche (35) und dem offenen Ende zu bilden, wobei "x" die axiale Abmessung zwischen der verdampfbaren Stirnfläche (35) und dem offenen Ende darstellt und "d" die Hauptabmessung des Querschnittes der verdampfbaren Stirnfläche (35) darstellt und wobei die Hülse (36) über ihre Länge hinweg eine im wesentlichen gleichförmige Querschnittsabmessung hat und zwischen der Kathode (15) und der Anode (18) in Abstand von diesen angeordnet ist,

einer Gasversorgungsanordnung (39) zum Einleiten eines Gasstromes in den engen Raum (40) zwischen der Kathode und dem umgebenden langgestreckten Bauteil durch die Kathodenkammer (37) hindurch und hinein in die Vakuumkammer (11); und

einer Evakuierungsanordnung zum Abziehen des in die Vakuumkammer (11) eingeleiteten Gases, um in der Vakuumkammer (11) einen vorbestimmten Druck aufrechtzuerhalten.

13. Vorrichtung nach Anspruch 12, wobei die Energieversorgungsanordnung zum Erzeugen des

8

elektrischen Lichtbogens eine außerhalb der Vakuumkammer (11) befindliche Energieversorgungsanordnung (46) aufweist.

14. Vorrichtung nach Anspruch 12 oder 13, wobei die die Kathode (15) umgebende Hülse (36) aus nichtmagnetischen Werkstoff besteht.

15. Vorrichtung nach einem der Ansprüche 12 bis 14, wobei die Hülse (36) eine geometrische Form hat, welche im wesentlichen der geometrischen Form der Kathode (15) entspricht.

16. Vorrichtung nach einem der Ansprüche 12 bis 15, wobei die Hülse (36) und die Kathode (15) zylindrische Form haben und der enge Raum (40) einen ringförmigen Querschnitt hat.

17. Vorrichtung nach einem der Ansprüche 12 bis 16, wobei die Anode ein integraler Teil der Vakuumkammer (11) ist.

18. Vorrichtung nach einem der Ansprüche 12 bis 17, wobei die Anode mit Massepotential verbunden ist.

19. Vorrichtung nach einem der Ansprüche 12 bis 16, wobei die Anode gegenüber der Vakuumkammer elektrisch isoliert ist.

20. Vorrichtung nach einem der Ansprüche 12 bis 19, wobei die Oberfläche eines elektrisch isolierten Bauteils (70) gegenüber der verdampfbaren Stirnfläche (35) der Kathode angeordnet ist.

21. Vorrichtung nach Anspruch 20, wobei das Objekt (14) zwischen der Oberfläche des elektrisch isolierten Bauteils (70) und der verdampfbaren Stirnfläche (35) der Kathode angeordnet ist.

22. Vorrichtung nach einem der Ansprüche 12 bis 21, wobei die Vakuumkammer einen Arbeitsdruck zwischen 13,3 und $6,675 \times 10^{-2}$ Pa ($10^{-1}$ und $5 \times 10^{-4}$ torr) hat.

## Revendications

1. Procédé de revêtement d'un objet avec une matière servant de source, dans une enceinte sous vide, à partir d'une cathode solide ayant une surface terminale évaporable distante d'une anode et orientée vers cet objet, comprenant les étapes consistant:

à engendrer un arc électrique entre la surface terminale évaporable de ladite cathode et ladite anode pour former un plasma contenant un quelconque ou plusieurs atomes, atomes ionisés, molécules et molécules ionisées de ladite surface terminale évaporable;

à entourer la cathode avec un élément allongé ayant une extrémité ouverte s'étendant sur une distance x/d comprise dans l'intervalle de 0,07 à 2 pour la formation d'une enceinte de cathode contenant ledit plasma entre ladite surface terminale évaporable (35) et ladite extrémité ouverte, "x" représentant la dimension axiale entre ladite surface terminale évaporable (35) et l'extrémité ouverte et "d" représentant la dimension principale de la section transversale de ladite surface terminale évaporable, l'élément allongé étant de dimension pratiquement uniforme en section transversale sur sa longueur et étant positionné entre ladite cathode et ladite anode et espacé de celles-ci;

à diriger un courant de gaz dans l'espace étroit entre la cathode et l'élément allongé qui l'entoure, à travers le plasma dans ladite enceinte de cathode et dans l'enceinte sous vide de sorte que le gaz enveloppe l'arc électrique sur au moins la distance "x" avant de pénétrer dans l'enceinte sous vide, la pression du gaz dans l'enceinte de cathode à plasma communiquant avec l'enceinte principale mise sous vide étant relativement plus élevée que la pression opératoire prédéterminée établie à l'intérieur de l'enceinte sous vide, et de sorte que le gaz soit introduit à une quantité telle que ladite pression opératoire soit maintenue dans un intervalle désiré; et

à décharger le gaz de l'enceinte sous vide pour maintenir une pression prédéterminée à l'intérieur de l'enceinte sous vide.

2. Procédé suivant la revendication 1, dans lequel le gaz est inerte et est choisi dans le groupe comprenant l'argon, le néon, le krypton, le xénon, l'hélium et leurs mélanges.

3. Procédé suivant la revendication 1, dans lequel le gaz est réactif et est choisi dans le groupe comprenant l'azote, l'oxygène, des hydrocarbures, l'anhydride carbonique, le monoxyde de carbone, le diborane, l'air, un silane et leurs mélanges.

4. Procédé suivant l'une des revendications précédentes, dans lequel le gaz sert d'isolant entre la cathode et l'élément allongé.

5. Procédé suivant l'une quelconque des revendications précédentes, dans lequel l'objet est polarisé négativement par rapport à l'anode.

6. Procédé suivant l'une des revendications précédentes, dans lequel l'objet est polarisé négativement par rapport à l'anode et à la cathode.

7. Procédé suivant la revendication 6, dans lequel le potentiel de polarisation négatif est compris dans l'intervalle de 50 à 400 volts.

8. Procédé suivant l'une des revendications précédentes, dans lequel l'enceinte sous vide est mise sous un vide correspondant à une pression opératoire de 13,3 à $6,675 \cdot 10^{-2}$ Pa ($10^{-1}$ à $5 \times 10^{-4}$ torr).

9. Procédé suivant l'une des revendications précédentes, dans lequel l'objet est déposé sur l'élément allongé à l'intérieur de l'enceinte de cathode pour former une buse convergente ayant un orifice de buse "y" supérieur à zéro et inférieur à 0,4 cm.

10. Procédé suivant l'une quelconque des revendications précédentes, dans lequel l'objet est constitué d'une matière choisie dans le groupe comprenant un métal réfractaire, un superalliage, l'acier inoxydable, des composites céramiques et un alliage de titane.

11. Procédé suivant l'une des revendications précédentes, dans lequel l'objet est positionné entre la surface terminale évaporable de la cathode solide et une surface isolée électriquement.

12. Appareil pour déposer une matière servant de source sur un objet (14) dans une enceinte sous vide (11) à partir d'une cathode (15) ayant une surface terminale évaporable (35) distante d'une anode (18) et tournée vers l'objet (14), comprenant:

des moyens d'alimentation en énergie (46) pour la production d'un arc électrique entre la surface terminale évaporable (35) de la cathode (15) et l'anode (18);

un manchon (36) entourant la cathode (15), ayant une extrémité ouverte dépassant d'une distance x/d comprise dans l'intervalle de 0,07 à 2 pour la formation d'une enceinte de cathode (37) contenant le plasma entre la surface terminale évaporable (35) et l'extrémité ouverte, "x" représentant la dimension axiale entre ladite surface terminale évaporable (35) et l'extrémité ouverte et "d" représentant la dimension principale de la section transversale de ladite surface terminale évaporable (35), ledit manchon (36) étant de dimensions pratiquement uniformes en section transversale sur sa longueur et étant positionné entre ladite cathode (15) et ladite anode (18) et espacé de celles-ci;

des moyens d'alimentation en gaz (39) pour diriger un courant de gaz dans l'espace étroit (40) entre la cathode et l'élément allongé qui l'entoure, à travers l'enceinte de cathode (37) et dans l'enceinte sous vide (11); et

des moyens de mise sous vide pour décharger le gaz injecté dans l'enceinte sous vide (11) pour maintenir une pression prédéterminée dans l'enceinte sous vide (11).

13. Appareil suivant la revendication 12, dans lequel les moyens d'alimentation en énergie pour la production de l'arc électrique comprennent des moyens d'alimentation en énergie (46) situés à l'extérieur de l'enceinte sous vide (11).

14. Appareil suivant la revendication 12 ou 13, dans lequel le manchon (36) entourant la cathode (15) est constitué d'une matière non magnétique.

15. Appareil suivant l'une des revendications 12 à 14, dans lequel le manchon (36) possède une forme géométrique correspondant pratiquement à la forme géométrique de la cathode (15).

16. Appareil suivant l'une des revendications 12 à 15, dans lequel le manchon (36) et la cathode (15) sont de forme cylindrique, l'espace étroit (40) étant annulaire en section transversale.

17. Appareil suivant l'une des revendications 12 à 16, dans lequel l'anode fait partie intégrante de l'enceinte sous vide (11).

18. Appareil suivant l'une des revendications 12 à 17, dans lequel l'anode est reliée au potentiel de la terre.

19. Appareil suivant l'une des revendications 12 à 16, dans lequel l'anode est isolée électriquement de l'enceinte sous vide.

20. Appareil suivant l'une des revendications 12 à 19, dans lequel la surface d'un élément isolé électriquement (70) est positionnée à l'opposé de la surface terminale évaporable (35) de la cathode.

21. Appareil suivant la revendication 20, dans lequel l'objet (14) est placé entre la surface de l'élément isolé électriquement (70) et la surface terminale évaporable (35) de la cathode.

22. Appareil suivant l'une des revendications 12 à 21, dans lequel l'enceinte sous vide est sous une pression opératoire de 13,3 à $6,675 \cdot 10^{-2}$ Pa ($10^{-1}$ à $5 \times 10^{-4}$ torr).

FIG. 1

# FIG. 2

## FIG.2A

## FIG.2C

## FIG.2B

F I G. 3A

F I G. 3B

# F I G. 4